# EUROPEAN PATENT APPLICATION

(11) **EP 4 361 646 A1**
(43) Date of publication of application: **01.05.2024**
(21) Application number: 22828228.1
(22) Date of filing: 08.06.2022
(51) Int. Cl.: G01R 1/06, G01R 1/067, G01R 31/26, H01R 13/24, H01R 33/76

(54) **SOCKET**

(30) Priority: 24.06.2021 JP 2021104560
(71) Applicant: Yokowo Co., Ltd., Tokyo 101-0041 (JP)
(72) Inventor: HOSOKAWA Daisuke, Tomioka-Shi, Gunma 370-2495 (JP)
(74) Representative: Gunzelmann, Rainer
(86) International application number: PCT/JP2022/023122
(87) International publication number: WO 2022/270311

(57) **Abstract**

A socket (10) includes a probe (100) having a first tapered portion (102) and an insulating support (200) provided with a through-hole (230) having a second tapered portion (202) to receive the first tapered portion (102). A first tapered angle (α) of the first tapered portion (102) is less than a second tapered angle (β) of the second tapered portion (202).

## Description

### TECHNICAL FIELD

The present invention relates to a socket.

### BACKGROUND ART

To inspect an object under inspection such as an integrated circuit, the object under inspection may be electrically connected to an inspection substrate via a socket. For example, as disclosed in Patent Document 1, a socket includes a probe and an insulating support provided with a through-hole through which the probe is disposed. The probe includes a first plunger adapted to contact with a first electrode of the object under inspection, a second plunger adapted to contact with a second electrode of the inspection substrate, and a spring. The inspection of the object under inspection includes contacting the second plunger with the second electrode of the inspection substrate, biassing the first plunger upward by the spring, and then contacting the first plunger with the first electrode of the object under inspection.

### RELATED DOCUMENT

### PATENT DOCUMENT

Patent Document 1: Japanese Patent Application Publication No. 2006-308486

### SUMMARY OF THE INVENTION

### TECHNICAL PROBLEM

To slide the probe in the through-hole of the insulating support, a gap is provided between an outer surface of the probe and an inner surface of the through-hole. The inspection of the object under inspection may include, after contacting the second plunger with the second electrode of the inspection substrate, biassing the first plunger upward with a tip of the first plunger opened (that is, an external force in a direction from the tip of the first plunger to a base end of the first plunger (a side opposite to the tip of the first plunger) not applied to the tip of the first plunger). In this case, however, the gap between the outer surface of the probe and the inner surface of the through-hole may cause inclination of the first plunger and deterioration of the positional accuracy of the tip of the first plunger.

An example of an object of the present invention is to improve the positional accuracy of a tip of a plunger. Other objects of the invention will become apparent from the description of the present specification.

### SOLUTION TO PROBLEM

An aspect of the present invention is a socket including a probe having a first tapered portion, and an insulating support provided with a through-hole having a second tapered portion to receive the first tapered portion, in which a tapered angle of the first tapered portion is less than a tapered angle of the second tapered portion.

### ADVANTAGEOUS EFFECTS OF INVENTION

According to the above aspect of the present invention, the positional accuracy of a tip of a plunger can be improved.

### BRIEF DESCRIPTION OF THE DRAWINGS

[Fig. 1] A cross-sectional view of a socket according to an embodiment.
[Fig. 2] A view illustrating a first plunger pressed toward an upper side of a through-hole with a first contact portion opened in the socket according to the embodiment.
[Fig. 3] An enlarged view of a portion of Fig. 2.
[Fig. 4] A view illustrating a first plunger pressed toward an upper side of a through-hole with a first contact portion opened in a socket according to a comparative embodiment.
[Fig. 5] An enlarged view of a portion of Fig. 4.

### DESCRIPTION OF EMBODIMENTS

Hereinafter, an embodiment of the present invention will be described with reference to the drawings. In all drawings, similar components are denoted by the similar reference signs, and description thereof will not be repeated.

In the present specification, ordinal numbers such as "first", "second", and "third" are added to simply distinguish components having similar names unless otherwise specified, and do not mean the particular feature of the component (for example, order or importance).

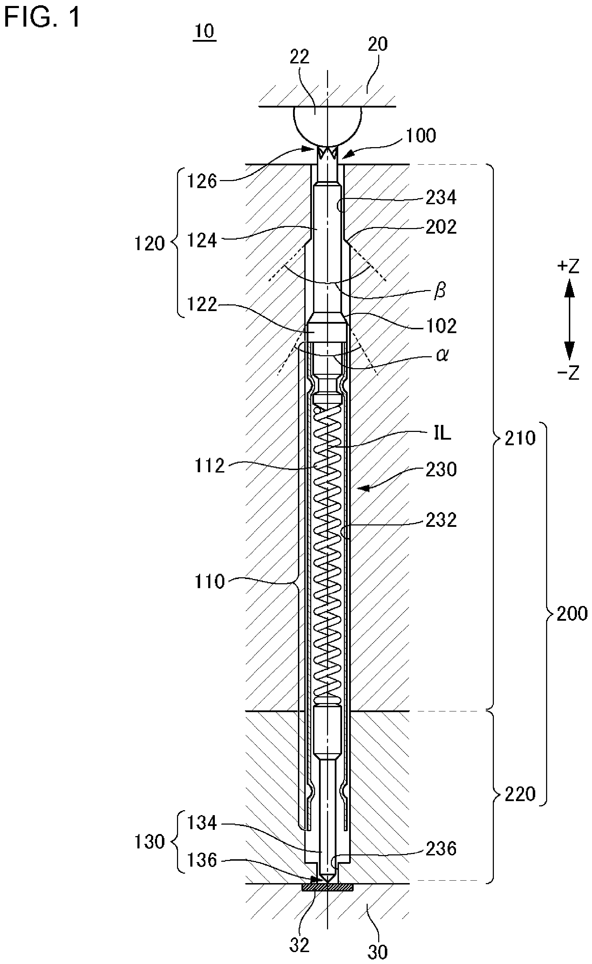

Fig. 1 is a cross-sectional view of a socket 10 according to an embodiment.

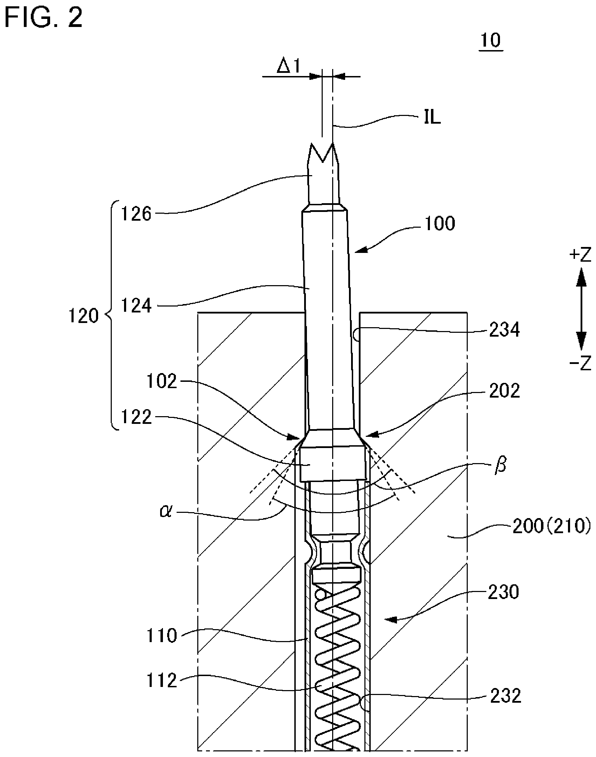

In Fig. 1, an arrow with "+Z" indicates an upward direction in the vertical direction, and an arrow with "-Z" indicates a downward direction in the vertical direction. Hereinafter, as necessary, a direction orthogonal to the vertical direction will be referred to as a horizontal direction. The same applies to Figs. 2 to 5.

The socket 10 is located between an object under inspection 20 and an inspection substrate 30 in the vertical direction. The object under inspection 20 is located above the socket 10. The inspection substrate 30 is located below the socket 10. The object under inspection 20 is, for example, an integrated circuit.

The socket 10 includes a probe 100 and an insulating support 200. A first electrode 22 provided on a lower surface of the object under inspection 20 and a second electrode 32 provided on an upper surface of the inspection substrate 30 are electrically connected to each other via the probe 100. In the present embodiment, the first electrode 22 is a bump, and the second electrode 32 is a pad. The probe 100 includes a tube 110, a spring 112, a first plunger 120, and a second plunger 130. The first plunger 120 includes a flange 122, a first column portion 124, and a first contact portion 126. The second plunger 130 includes a second column portion 134 and a second contact portion 136. The insulating support 200 includes a first insulating support 210 and a second insulating support 220.

The tube 110 extends parallel to the vertical direction. The first plunger 120 is provided at an upper end of the tube 110. The second plunger 130 is provided at a lower end of the tube 110. The spring 112 is provided in the tube 110. The spring 112 biases the first plunger 120 and the second plunger 130 in a direction away from each other in the vertical direction. In another example different from the present embodiment, the tube 110 may not be provided, and the spring 112 may be provided between the first plunger 120 and the second plunger 130 in the vertical direction.

The flange 122 is located above an upper end of the tube 110. The value of the diameter of the flange 122 in the horizontal direction is substantially equal to the value of the outer diameter of the tube 110 in the horizontal direction. The first column portion 124 extends upward from the upper end of the flange 122 in the vertical direction. The value of the diameter of the first column portion 124 in the horizontal direction is less than the value of the diameter of the flange 122 in the horizontal direction. The first contact portion 126 is provided at a tip of the first column portion 124, that is, at an upper end of the first column portion 124. In the inspection of the object under inspection 20, the first contact portion 126 is in contact with the first electrode 22 with the tube 110 and the first plunger 120 integrally biased toward the object under inspection 20 by the spring 112.

The second column portion 134 extends in the vertical direction. The value of the diameter of the second column portion 134 in the horizontal direction is less than the value of the inner diameter of the tube 110 in the horizontal direction. The second column portion 134 is attached to the tube 110 to be movable in the vertical direction with at least a portion of the second column portion 134 inserted into a hole provided at the lower end of the tube 110. The second contact portion 136 is provided at the tip of the second column portion 134, that is, at a lower end of the second column portion 134. In the inspection of the object under inspection 20, the second contact portion 136 is in contact with the second electrode 32 with the second plunger 130 biased toward the inspection substrate 30 by the spring 112.

The first insulating support 210 and the second insulating support 220 overlap each other in the vertical direction. The first insulating support 210 is located above the second insulating support 220. The second insulating support 220 is located below the first insulating support 210. The first insulating support 210 is, for example, a pin block, and the second insulating support 220 is, for example, a pin plate.

The insulating support 200 is provided with a through-hole 230. The through-hole 230 extends through the insulating support 200 in the vertical direction. The through-hole 230 includes a first hole 232, a second hole 234, and a third hole 236. At least a portion of the probe 100 is disposed through the through-hole 230 in the vertical direction.

The first hole 232 extends through in the vertical direction a portion of the first insulating support 210 including a lower end and a central portion in the vertical direction of the first insulating support 210, and a portion of the second insulating support 220 including an upper end and a central portion in the vertical direction of the second insulating support 220. A portion of the first hole 232 through the lower end of the first insulating support 210 and a portion of the first hole 232 through the upper end of the second insulating support 220 communicate with each other in the vertical direction. At least a portion of the tube 110 and at least a portion of the flange 122 are disposed through the first hole 232 in the vertical direction. The value of the diameter of the first hole 232 of the first insulating support 210 in the horizontal direction is greater than any of the value of the outer diameter of a portion of the tube 110 disposed through the first hole 232 of the first insulating support 210 in the horizontal direction, and the value of the diameter of the flange 122 in the horizontal direction. The value of the diameter of the first hole 232 of the second insulating support 220 in the horizontal direction is greater than the value of the outer diameter of a portion of the tube 110 disposed through the first hole 232 of the second insulating support 220 in the horizontal direction. Thus, a gap is provided between the outer surface of the portion of the tube 110 disposed through the first hole 232 of the first insulating support 210 and the inner surface of the first hole 232 of the first insulating support 210, and between the outer surface of the flange 122 and the inner surface of the first hole 232 of the first insulating support 210. A gap is provided between the outer surface of the portion of the tube 110 disposed through the first hole 232 of the second insulating support 220 and the inner surface of the first hole 232 of the second insulating support 220. The tube 110 and the flange 122 are therefore slidable in the first hole 232 in the vertical direction.

The second hole 234 extends in the vertical direction through a portion of the first insulating support 210 including the upper end of the first insulating support 210. The lower end of the second hole 234 communicates with the upper end of the first hole 232 in the vertical direction. At least a portion of the first column portion 124 is disposed through the second hole 234. The value of the diameter of the second hole 234 in the horizontal direction is less than the value of the diameter of the first hole 232 in the horizontal direction. The value of the diameter of the second hole 234 in the horizontal direction is equal to or less than the value of the outer diameter of the tube 110 in the horizontal direction, equal to or less than the value of the diameter of the flange 122 in the horizontal direction, and greater than the value of the diameter of the first column portion 124 in the horizontal direction. Thus, the tube 110 and the flange 122 are refrained from escaping upward through the second hole 234. A gap is provided between the outer surface of the first column portion 124 and the inner surface of the second hole 234. The first column portion 124 is therefore slidable in the second hole 234 in the vertical direction.

The third hole 236 extends in the vertical direction through a portion of the second insulating support 220 including the lower end of the second insulating support 220. The upper end of the third hole 236 communicates with the lower end of the first hole 232 in the vertical direction. At least a portion of the second column portion 134 is disposed through the third hole 236 in the vertical direction. The value of the diameter of the third hole 236 in the horizontal direction is less than the value of the diameter of the first hole 232 in the horizontal direction. The value of a diameter of the third hole 236 in the horizontal direction is equal to or less than the value of the outer diameter of the tube 110 in the horizontal direction and greater than the value of the diameter of the second column portion 134 in the horizontal direction. Thus, the tube 110 is refrained from escaping downward through the third hole 236. A gap is provided between the outer surface of the second column portion 134 and the inner surface of the third hole 236. The second column portion 134 is therefore slidable in the third hole 236 in the vertical direction.

The first plunger 120 has a first tapered portion 102. The first tapered portion 102 is located between the upper end of the flange 122 and the lower end of the first column portion 124 in the vertical direction. A value of the diameter of the first plunger 120 at the first tapered portion 102 in the horizontal direction decreases from the upper end of the flange 122 toward the lower end of the first column portion 124. A first tapered angle α, which is a tapered angle of the first tapered portion 102, is the total of angles that the outer surfaces of opposite sides of the first plunger 120 in the horizontal direction at the first tapered portion 102 make with respect to an imaginary line IL passing through the horizontal direction center of the through-hole 230 in parallel with an extension direction of the through-hole 230. The first tapered angle α is also an angle between tangent lines of the outer surfaces of opposite sides of the first plunger 120 in the horizontal direction at the first tapered portion 102.

The through-hole 230 has a second tapered portion 202. The second tapered portion 202 is located between the upper end of the first hole 232 and the lower end of the second hole 234 in the vertical direction. The value of the diameter of the through-hole 230 at the second tapered portion 202 in the horizontal direction decreases from the upper end of the first hole 232 toward the lower end of the second hole 234. A second tapered angle β, which is a tapered angle of the second tapered portion 202, is the total of angles that the inner surfaces of opposite sides of the through-hole 230 in the horizontal direction at the second tapered portion 202 make with respect to the imaginary line IL passing through the horizontal direction center of the through-hole 230 in parallel with the extension direction of the through-hole 230. The second tapered angle β is also an angle between tangent lines of the inner surfaces of opposite sides of the through-hole 230 in the horizontal direction at the second tapered portion 202.

In the embodiment, the first tapered angle α of the first tapered portion 102 is less than the second tapered angle β of the second tapered portion 202.

The ratio of the first tapered angle α to the second tapered angle β may be, but is not limited to, for example, 3/5 or greater (that is, 90 % or greater of 2/3) and 33/40 or less (that is, 110 % or less of 3/4).

The first tapered angle α may be, but is not limited to, for example, 55.0° or greater and 95.0° or less, 57.5° or greater and 92.5° or less, or 60.0° or greater and 90.0° or less.

The second tapered angle β may be, but is not limited to, for example, 85.0° or greater and 125.0° or less, 87.5° or greater and 122.5° or less, or 90.0° or greater and 120.0° or less.

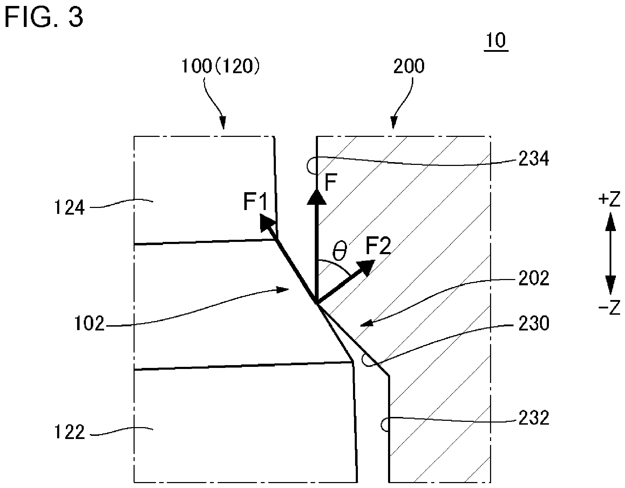

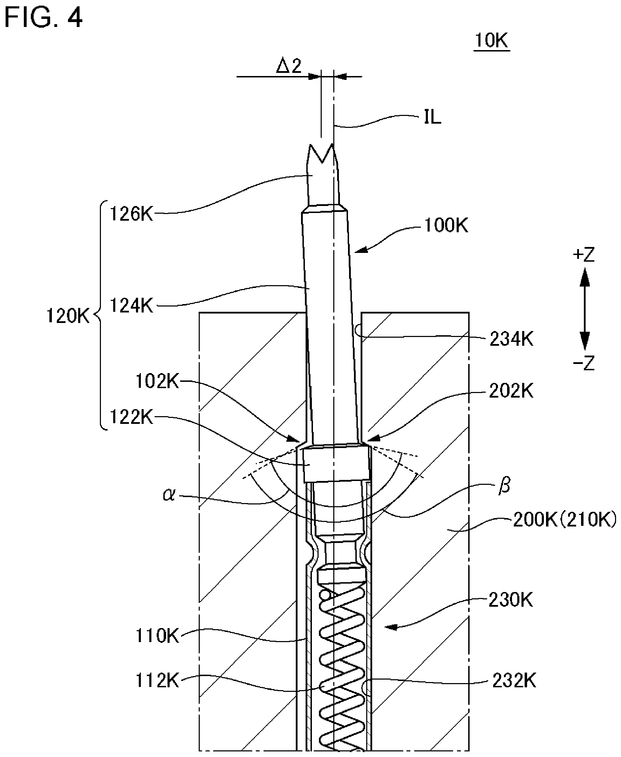

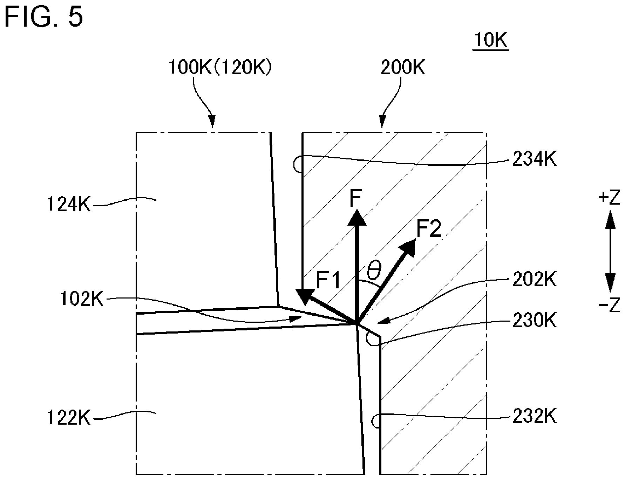

Fig. 2 is a view illustrating the first plunger 120 pressed toward an upper side of the through-hole 230 with the first contact portion 126 opened in the socket 10 according to the embodiment. Fig. 3 is an enlarged view of a portion of Fig. 2. Fig. 4 is a view illustrating a first plunger 120K pressed toward an upper side of a through-hole 230K with a first contact portion 126K opened in a socket 10K according to a comparative embodiment. Fig. 5 is an enlarged view of a portion of Fig. 4.

The embodiment shown in Figs. 2 and 3 will be described with reference to Fig. 1.

In the embodiment shown in Figs. 2 and 3, the second contact portion 136 is in contact with the second electrode 32 with the first contact portion 126 opened, that is, an external force in the downward direction not applied to the first contact portion 126 by first contact portion 126 not in contact with an object such as the first electrode 22. The tube 110 and the first plunger 120 are integrally biased upward by the spring 112, and the first plunger 120 is pressed toward the upper side of the through-hole 230.

In the embodiment shown in Figs. 2 and 3, as viewed from a direction perpendicular to the paper surface in Figs. 2 and 3, the first plunger 120 is inclined to the left side from the vertical direction by the gap between the outer surface of the first column portion 124 and the inner surface of the second hole 234. As viewed from the direction perpendicular to the paper surface in Fig. 2, the first contact portion 126 is thus shifted by a first distance Δ1 toward the left side from the imaginary line IL passing through the horizontal direction center of the through-hole 230 in parallel with the vertical direction. The inclination of the first plunger 120 from the vertical direction is not limited to the embodiment shown in Figs. 2 and 3. For example, the first plunger 120 may be inclined to the right side from the vertical direction as viewed from the direction perpendicular to the paper surface in Figs. 2 and 3.

As shown in Fig. 3, a corner of the through-hole 230 between the upper end of the inner surface of the second tapered portion 202 and the lower end of the inner surface of the second hole 234 receives the first tapered portion 102. The first tapered portion 102 is pressed toward the second tapered portion 202 by the first plunger 120 pressed toward the upper side of the through-hole 230 by the spring 112, and a preload load F is applied to the first tapered portion 102 at a contact portion of the first tapered portion 102 and the second tapered portion 202.

The preload load F in the embodiment is decomposed into a first component force F1 illustrated by Fsinθ and a second component force F2 illustrated by Fcosθ. The angle θ is an angle between a direction from the bottom to the top in parallel with the vertical direction and a direction from a side on which the first tapered portion 102 is located toward a side on which the second tapered portion 202 is located in a direction parallel to the normal line of the outer surface of the first tapered portion 102. The first component force F1 is a force to bias the first plunger 120 toward the horizontal direction center of the through-hole 230. The second component force F2 is a force to contribute to a frictional force preventing the first plunger 120 from moving in the tangential direction of the outer surface of the first tapered portion 102 toward the horizontal direction center of the through-hole 230.

After the state shown in Figs. 2 and 3, the first electrode 22 is brought into contact with the first contact portion 126 to compress the spring 112 in the vertical direction. Thus, as shown in Fig. 1, the first contact portion 126 contacts with the first electrode 22 with the tube 110 and the first plunger 120 integrally biased upward.

Next, a comparative embodiment shown in Figs. 4 and 5 will be described. A socket 10K according to the comparative embodiment is similar to the socket 10 according to the embodiment except for the following points.

A first plunger 120K is biased upward by a spring 112K provided in a tube 110K. The first plunger 120K has a first tapered portion 102K. The first tapered portion 102K is located between the upper end of a flange 122K and the lower end of a first column portion 124K in the vertical direction. A value of the diameter of the first plunger 120K in a first tapered portion 102K in the horizontal direction decreases from the upper end of the flange 122K toward the lower end of the first column portion 124K.

A through-hole 230K of an insulating support 200K (a first insulating support 210K) has a second tapered portion 202K. The second tapered portion 202K is located between the upper end of a first hole 232K and the lower end of a second hole 234K in the vertical direction. The value of the diameter of the through-hole 230K in the second tapered portion 202K in the horizontal direction decreases from the upper end of the first hole 232K toward the lower end of the second hole 234K.

In the comparative embodiment, a first tapered angle α of the first tapered portion 102K is equal to or greater than a second tapered angle β of the second tapered portion 202K.

In the embodiment shown in Figs. 4 and 5, as viewed from a direction perpendicular to the paper surface in Figs. 4 and 5, the first plunger 120K is inclined to the left side from the vertical direction by the gap between the outer surface of the first column portion 124K and the inner surface of the second hole 234K. As viewed from the direction perpendicular to the paper surface in Fig. 4, the first contact portion 126K is thus shifted by a second distance Δ2 toward the left side from the imaginary line IL passing through the horizontal direction center of the through-hole 230K in parallel with the vertical direction.

As shown in Fig. 5, the second tapered portion 202K receives a corner of the first plunger 120K between a lower end of an outer surface of the first tapered portion 102K and an upper end of an outer surface of the flange 122K. The first tapered portion 102K is pressed toward the second tapered portion 202K by the first plunger 120K pressed toward the upper side of the through-hole 230K by the spring 112K, and a preload load F is applied to the first plunger 120K at a contact portion of the first tapered portion 102K and the second tapered portion 202K.

The preload load F in the comparative embodiment is decomposed into a first component force F1 illustrated by Fsinθ and a second component force F2 illustrated by Fcosθ. The angle θ indicates an angle between a direction from the bottom to the top in parallel with the vertical direction and a direction from a side on which the first tapered portion 102K is located toward a side on which the second tapered portion 202K is located in a direction parallel to the normal line of the inner surface of the second tapered portion 202K. The first component force F1 is a force to bias the flange 122K toward the horizontal direction center of the through-hole 230K. The second component force F2 is a force to contribute to a frictional force preventing the flange 122K from moving in the tangential direction of the inner surface of the second tapered portion 202K toward the center of the through-hole 230K.

The first distance Δ1 of the shift of the first contact portion 126 from the imaginary line IL in the horizontal direction in the embodiment can be less than the second distance Δ2 of the shift of the first contact portion 126K from the imaginary line IL in the horizontal direction in the comparative embodiment. The reason is as follows. That is, in the embodiment, as viewed from the direction perpendicular to the paper surface in Fig. 3, a torque to rotate the first plunger 120 counterclockwise may be generated by the preload load F. Also in the comparative embodiment, as viewed from the direction perpendicular to the paper surface in Fig. 5, a torque to rotate the first plunger 120K counterclockwise may also be generated by the preload load F. A distance from the horizontal direction center of the first plunger 120 to a position at which the preload load F is applied in the embodiment is however shorter than a distance from the horizontal direction center of the first plunger 120K to a position at which the preload load F is applied in the comparative embodiment. The above torque generated by the preload load F in the embodiment can be therefore less than the above torque generated by the preload load F in the comparative embodiment. The first distance Δ1 of the shift of the first contact portion 126 from the imaginary line IL in the horizontal direction in the embodiment can be accordingly less than the second distance Δ2 of the shift of the first contact portion 126K from the imaginary line IL in the horizontal direction in the comparative embodiment.

From the above-described relationship between the first distance Δ1 in the embodiment and the second distance Δ2 in the comparative embodiment, the positional accuracy of the tip of the first plunger 120 in the embodiment can be better than the positional accuracy of the tip of the first plunger 120K in the comparative embodiment. That is, the positional accuracy of the first contact portion 126 in the embodiment in the horizontal direction can be better than the positional accuracy of the first contact portion 126K in the horizontal direction in the comparative embodiment.

Also, from the above-described relationship between the first distance Δ1 in the embodiment and the second distance Δ2 in the comparative embodiment, in the embodiment, the outer surface of the first column portion 124 and the inner surface of the second hole 234 are less likely to contact with each other when the first plunger 120 is pressed toward the upper side of the through-hole 230, as compared with the comparative embodiment. The width of the gap between the outer surface of the first column portion 124 and the inner surface of the second hole 234 in the horizontal direction in the embodiment can be therefore narrower than the width of the gap between the outer surface of the first column portion 124K and the inner surface of the second hole 234K in the horizontal direction in the comparative embodiment.

In the embodiment, the first tapered angle α may be an acute angle. The outer surface of the first tapered portion 102 can be more likely to slide on the corner of the through-hole 230 between the upper end of the inner surface of the second tapered portion 202 and the lower end on the inner surface of the second hole 234, and the first plunger 120 can be more likely to be biased toward the horizontal direction center of the through-hole 230 when the first tapered angle α is an acute angle than when the first tapered angle α is a right angle or an obtuse angle.

In the embodiment, a coefficient of static friction and a coefficient of dynamic friction between the outer surface of the first tapered portion 102 and the corner the through-hole 230 between the upper end of the second tapered portion 202 and the lower end of the second hole 234 may be equal to or less than a predetermined value. The outer surface of the first tapered portion 102 can be more likely to slide on the corner of the through-hole 230 between the upper end of the second tapered portion 202 and the lower end of the second hole 234, and the first plunger 120 can be more likely to be biased toward the horizontal direction center of the through-hole 230 when the coefficient of static friction and the coefficient of dynamic friction are equal to or less than the predetermined value than when the coefficient of static friction and the coefficient of dynamic friction are greater than the predetermined value.

### EXAMPLES

Table 1 shows relationships among a first tapered angle α, a second angle tapered angle β, a distance Δ, an angle θ, a ratio F1/F, a ratio F2/F, and a ratio F1/F2 in a simulation of the socket according to each of Example 1, Example 2, Comparative Example 1, and Comparative Example 2.

**[Table 1]**

| | Example 1 | Example 2 | Comparative Example 1 | Comparative Example 2 |
|---|---|---|---|---|
| α (°) | 60 | 90 | 150 | 90 |
| β (°) | 90 | 120 | 120 | 90 |
| Δ (µm) | 15.3 | 18.2 | 18.9 | 18.6 |
| θ (°) | 58.1 | 42.4 | 30 | 45 |
| F1/F | 0.849 | 0.674 | 0.5 | 0.707 |
| F2/F | 0.528 | 0.738 | 0.866 | 0.707 |
| F1/F2 | 1.61 | 0.91 | 0.58 | 1.00 |

Each numerical value in the row of "α (°)" in Table 1 indicates the first tapered angle α (unit: °). The first tapered angle α according to Examples 1 and 2 corresponds to the first tapered angle α of the first tapered portion 102 described in the embodiment. The first tapered angle α according to Comparative Examples 1 and 2 corresponds to the first tapered angle α of the first tapered portion 102K described in the comparative embodiment.

Each numerical value in the row of "β (°)" in Table 1 indicates the second tapered angle β (unit: °). The second tapered angle β according to Examples 1 and 2 corresponds to the second tapered angle β of the second tapered portion 202 described in the embodiment. The second tapered angle β according to Comparative Examples 1 and 2 corresponds to the second tapered angle β of the second tapered portion 202K described in the comparative embodiment.

Each numerical value in the row of "Δ (pm)" in Table 1 indicates the distance Δ (unit: um). The distance Δ in Examples 1 and 2 corresponds to the first distance Δ1 of the shift of the first contact portion 126 from the imaginary line IL in the horizontal direction described in the embodiment. The distance Δ in Comparative Examples 1 and 2 corresponds to the second distance Δ2 of the shift of the first contact portion 126K from the imaginary line IL in the horizontal direction described in the comparative embodiment.

Each numerical value in the row of "F1/F" in Table 1 indicates the ratio of the first component force F1 to the preload load F. Each numerical value in the row of "F2/F" in Table 1 indicates the ratio of the second component force F2 to the preload load F. Each numerical value in the row of "F1/F2" in Table 1 indicates the ratio of the first component force F1 to the second component force F2. The preload load F, the first component force F1, and the second component force F2 in Examples 1 and 2 correspond to the preload load F, the first component force F1, and the second component force F2 described in the embodiment, respectively. The preload load F, the first component force F1, and the second component force F2 in Comparative Examples 1 and 2 correspond to the preload load F, the first component force F1, and the second component force F2 described in the comparative embodiment, respectively.

In the simulations of Examples 1 and 2, and Comparative Examples 1 and 2, the first tapered angle α and the second tapered angle β were as shown in Table 1. In this simulation, the distance Δ, the angle θ, the ratio F1/F, the ratio F2/F, and the ratio F1/F2 were as shown in Table 1.

The comparison between Examples 1 and 2 and Comparative Examples 1 and 2 would indicate that the distance Δ when the first tapered angle α is less than the second angle β can be less than the distance Δ when the first tapered angle α is equal to or greater than the second tapered angle β.

The comparison between Example 1 and Example 2 would indicate that when the first tapered angle α is less than the second angle β, the distance Δ can be reduced as the ratio F1/F2 increases. Also, the comparison between Example 1 and Example 2 would indicate that the distance Δ when the first tapered angle α is an acute angle can be less than the distance Δ when the first tapered angle α is a right angle.

From Examples 1 and 2, the ratio of the first tapered angle α to the second tapered angle β may be, for example, equal to or greater than 3/5 and equal to or less than 33/40. The lower limit 3/5 of this numerical range indicates 90 % of the ratio 2/3 of the first tapered angle α to the second tapered angle β in Example 1. The upper limit 33/40 of the numerical range indicates 110 % of the ratio 3/4 of the first tapered angle α to the second tapered angle β in Example 2.

From Example 1, the first tapered angle α may be equal to or greater than 58.0° and equal to or less than 62.0°, equal to or greater than 58.5° and equal to or less than 61.5°, or equal to or greater than 59.0° and equal to or less than 61.0°, and the second tapered angle β may be equal to or greater than 88.0° and equal to or less than 92.0°, equal to or greater than 88.5 and equal to or less than 91.5°, or equal to or greater than 89.0° and equal to or less than 91.0°. The above numerical range of the first tapered angle α is estimated from 60° of the first tapered angle α in Example 1 and the tolerance thereof. The above numerical range of the second tapered angle β is estimated from 90° of the second tapered angle β in Example 1 and the tolerance thereof.

Hitherto, the embodiment and examples of the present invention have been described above with reference to the drawings, but these are examples of the present invention, and various configurations other than the above description may be adopted.

For example, a portion of the outer surface of the probe 100 located between the tube 110 and the second plunger 130 in the vertical direction may be provided with a third tapered portion having a value of the diameter of the probe 100 in the horizontal direction that decreases from the top to the bottom. Also, a portion of the inner surface of the through-hole 230 located between the first hole 232 and the third hole 236 in the vertical direction may be provided with a fourth tapered portion having a value of the diameter of the through-hole 230 in the horizontal direction that decreases from the top to the bottom. When the second plunger 130 is pressed downward, the fourth tapered portion receives the third tapered portion. A third tapered angle of the third tapered portion is less than a fourth tapered angle of the fourth tapered portion. The positional accuracy of the tip of the second plunger 130 when the third tapered angle is less than the fourth tapered angle, that is, the positional accuracy of the second contact portion 136 in the horizontal direction is better than the positional accuracy of the tip of the second plunger 130 when the third tapered angle is equal to or greater than the fourth tapered angle, that is, the positional accuracy of the second contact portion 136 in the horizontal direction.

According to this specification, the following aspects are provided.

### (Aspect 1)

Aspect 1 is a socket including
a probe having a first tapered portion, and
an insulating support provided with a through-hole having a second tapered portion to receive the first tapered portion,
in which a tapered angle of the first tapered portion is less than a tapered angle of the second tapered portion.

According to Aspect 1, the inclination of the plunger provided with the first tapered portion can be reduced while the first tapered portion is pressed toward the second tapered portion as compared with when the tapered angle of the first tapered portion is equal to or greater than the tapered angle of the second tapered portion. The positional accuracy of the tip of the plunger in Aspect 1 can be therefore better than the positional accuracy of the tip of the plunger when the tapered angle of the first tapered portion is equal to or greater than the tapered angle of the second tapered portion. The tapered angle of the first tapered portion is the total of angles that the outer surfaces of opposite sides of the probe at the first tapered portion make with respect to the imaginary line passing through the center of the through-hole in parallel with the extension direction of the through-hole. The tapered angle of the second tapered portion is the total of angles that the inner surfaces of opposite sides of the through-hole at the second tapered portion make with respect to the imaginary line passing through the center of the through-hole in parallel with the extension direction of the through-hole.

### (Aspect 2)

Aspect 2 is the socket disclosed in Aspect 1, in which the tapered angle of the first tapered portion is an acute angle.

According to Aspect 2, the outer surface of the first tapered portion can be more likely to slide on the through-hole, and the plunger provided with the first tapered portion can be more likely to be biased toward the center of the through-hole than when the tapered angle of the first tapered portion is a right angle or an obtuse angle.

This application claims priority based on Japanese application Japanese Patent Application No. 2021-104560 filed on June 24, 2021, the disclosure of which is incorporated herein in its entirety by reference.

### REFERENCE SIGNS LIST

10, 10K socket, 20 object under inspection, 22 first electrode, 30 inspection substrate, 32 second electrode, 100 probe, 102, 102K first tapered portion, 110, 110K tube, 112, 112K spring, 120, 120K first plunger, 122, 122K flange, 124, 124K first column portion, 126, 126K first contact portion, 130 second plunger, 134 second column portion, 136 second contact portion, 200, 200K insulating support, 202, 202K second tapered portion, 210, 210K first insulating support, 220 second insulating support, 230, 230K through-hole, 232, 232K first hole, 234, 234K second hole, 236 third hole, IL imaginary line

## Claims

1. A socket comprising:
a probe having a first tapered portion; and
an insulating support provided with a through-hole having a second tapered portion to receive the first tapered portion,
wherein a tapered angle of the first tapered portion is less than a tapered angle of the second tapered portion.

2. The socket according to claim 1,
wherein the tapered angle of the first tapered portion is an acute angle.
